# EUROPEAN PATENT APPLICATION

(11) **EP 3 160 216 A1**
(43) Date of publication of application: **26.04.2017**
(21) Application number: 15290273.0
(22) Date of filing: 21.10.2015
(51) Int. Cl.: H05K 1/03, H01Q 9/04, D04B 1/12

(54) **TEXTILE-BASED ANTENNA SYSTEM AND ENERGY HARVESTING SYSTEM**

(71) Applicant: NXP B.V., 5656 AG Eindhoven (NL)
(72) Inventor: Gamand, Patrice, 12906 Caen (FR); Ansari, Kimia, Redhill, Surrey RH1 1SH (GB)
(74) Representative: Hardingham, Christopher Mark

(57) **Abstract**

Embodiments of a system are disclosed. In an embodiment, a system includes conductive textile portions and non-conductive textile portions. The conductive textile portions have conductive fibers and the non-conductive textile portions have non-conductive fibers. The conductive textile portions are connected to the non-conductive textile portions in the form of a coplanar antenna system.

## Description

### BACKGROUND

Electronic components, including wearable electronics, are becoming a more integral part of everyday life. As electronic components become a more integral part of everyday life, there is a constant need to provide energy to those electronic components. Systems for harvesting energy from microwave electromagnetic fields are known. However, such systems are not always compatible with emerging applications such as wearable electronics.

### SUMMARY

Embodiments of a system are disclosed. In an embodiment, a system includes conductive textile portions and non-conductive textile portions. The conductive textile portions have conductive fibers and the non-conductive textile portions have non-conductive fibers. The conductive textile portions are connected to the non-conductive textile portions in the form of a coplanar antenna system.

In an embodiment, the conductive textile portions have top and bottom major surfaces and perimeter edges and the non-conductive textile portions have top and bottom major surfaces and perimeter edges and the conductive textile portions are connected to the non-conductive textile portions at the respective perimeter edges.

In an embodiment, the conductive textile portions include a conductive textile patch, a conductive textile signal line electrically connected to the conductive textile patch, and a conductive textile ground plane. The non-conductive textile portions electrically separate the conductive textile patch and the conductive textile signal line from the conductive textile ground plane. In an embodiment, the system includes a signal line interface coupled to the conductive textile signal line and at least two ground plane interfaces coupled to the conductive textile ground plane.

In an embodiment, the coplanar antenna system includes an array of patch antennas formed from the conductive textile portions and the non-conductive textile portions. In an embodiment, the coplanar antenna system includes a combiner, formed from the conductive textile portions and the non-conductive textile portions, which electrically connects the array of patch antennas. In an embodiment, the coplanar antenna system includes a filter, formed from the conductive textile portions and the non-conductive textile portions, which filters an output of the combiner.

In an embodiment, the coplanar antenna system includes a filter, formed from the conductive textile portions and the non-conductive textile portions, which filters a signal from the coplanar antenna system.

An antenna system is also discloses. The antenna system includes a conductive textile patch, a conductive textile signal line electrically connected to the conductive textile patch, a conductive textile ground plane, and non-conductive textile portions that electrically separate the conductive textile patch and the conductive textile signal line from the conductive textile ground plane. The conductive textile patch, the conductive textile signal line, the conductive textile ground plane, and the non-conductive textile portions are connected to each other in the same plane.

In an embodiment, the conductive textile patch, the conductive textile signal line, and the conductive textile ground plane have top and bottom major surfaces and perimeter edges and the non-conductive textile portions have top and bottom major surfaces and perimeter edges and wherein the conductive textile portions are connected to the non-conductive textile portions at the respective perimeter edges.

In an embodiment, the conductive textile patch, the conductive textile signal line, and the conductive textile ground plane comprise interlaced conductive fibers and wherein the non-conductive textile portions comprise interlaced non-conductive fibers.

In an embodiment, the conductive textiles and non-conductive textiles are connected to each other by interlacing of respective conductive and non-conductive fibers.

In an embodiment, the antenna system includes a signal line interface coupled to the conductive textile signal line and at least two ground plane interfaces coupled to the conductive textile ground plane.

In an embodiment, at least some of the non-conductive textile portions surround the conductive textile patch and the conductive textile signal line.

In an embodiment, the antenna system further includes an antenna array and a combiner, formed from conductive textile portions and non-conductive textile portions, wherein the combiner electrically connects signal lines of the antenna array. In an embodiment, a filter, formed from conductive textile portions and non-conductive textile portions, filters an output of the combiner.

An embodiment of a system is disclosed. The system includes an antenna array formed of coplanar conductive textile portions and non-conductive textile portions, where signal elements and ground elements of the antenna array are formed from the conductive textile portions and the signal elements of the antenna array are electrically insulated from the ground elements of the antenna array by at least one of the non-conductive textile portions.

In an embodiment, the conductive textile portions include interlaced conductive fibers and the non-conductive textile portions comprise interlaced non-conductive fibers.

In an embodiment, the system further includes a combiner, formed from conductive textile portions and non-conductive textile portions, which electrically connects signal elements of the antenna array. In an embodiment, the system further includes a filter, formed from the conductive textile portions and the non-conductive textile portions, which filters an output of the combiner.

Other aspects in accordance with the invention will become apparent from the following detailed description, taken in conjunction with the accompanying drawings, illustrated by way of example of the principles of the invention.

### BRIEF DESCRIPTION OF THE DRAWINGS

Fig. 1 depicts a system for harvesting energy that includes a rectenna.
Fig. 2 depicts a system for harvesting energy in which a rectenna includes an antenna array.
Fig. 3 depicts a system for harvesting energy that includes an antenna array, multiple parallel filters, multiple parallel rectifiers, and multiple parallel low-pass filters.
Fig. 4 depicts an embodiment of a microstrip antenna as is known in the field.
Fig. 5 depicts an embodiment of a coplanar antenna as is known in the field.
Figs. 6A and 6B depict an embodiment of a coplanar patch antenna that can be used in an energy harvesting system.
Figs. 7A - 7E depict an example of an antenna system in accordance with an embodiment of the invention.
Fig. 8 is an example simulation of the antenna system of Figs. 7A - 7E.
Figs. 9A - 9D depict an embodiment of an antenna system that includes conductive textile portions and non-conductive textile portions formed into a coplanar antenna array.
Fig. 10 depicts an example embodiment of a filter that is formed from coplanar portions of conductive and non-conductive textiles.
Figs. 11A and 11B depict an embodiment of an energy harvesting system that includes a textile-based antenna system.
Fig. 12 depicts an expanded view of a conductive textile and a non-conductive textile that are connected to each other side-by-side in an interlaced manner.
Fig. 13 depicts an expanded view of a conductive textile and a non-conductive textile that are connected to each other side-by-side in an embedded manner.
Fig. 14 depicts an embodiment of a garment, such as a shirt, which includes an antenna system and/or energy harvesting system, as described above with reference to Figs. 7A - 13, integrated into the garment.

Throughout the description, similar reference numbers may be used to identify similar elements.

### DETAILED DESCRIPTION

It will be readily understood that the components of the embodiments as generally described herein and illustrated in the appended figures could be arranged and designed in a wide variety of different configurations. Thus, the following more detailed description of various embodiments, as represented in the figures, is not intended to limit the scope of the present disclosure, but is merely representative of various embodiments. While the various aspects of the embodiments are presented in drawings, the drawings are not necessarily drawn to scale unless specifically indicated.

The present invention may be embodied in other specific forms without departing from its spirit or essential characteristics. The described embodiments are to be considered in all respects only as illustrative and not restrictive. The scope of the invention is, therefore, indicated by the appended claims rather than by this detailed description. All changes which come within the meaning and range of equivalency of the claims are to be embraced within their scope.

Reference throughout this specification to features, advantages, or similar language does not imply that all of the features and advantages that may be realized with the present invention should be or are in any single embodiment of the invention. Rather, language referring to the features and advantages is understood to mean that a specific feature, advantage, or characteristic described in connection with an embodiment is included in at least one embodiment of the present invention. Thus, discussions of the features and advantages, and similar language, throughout this specification may, but do not necessarily, refer to the same embodiment.

Furthermore, the described features, advantages, and characteristics of the invention may be combined in any suitable manner in one or more embodiments. One skilled in the relevant art will recognize, in light of the description herein, that the invention can be practiced without one or more of the specific features or advantages of a particular embodiment. In other instances, additional features and advantages may be recognized in certain embodiments that may not be present in all embodiments of the invention.

Reference throughout this specification to "one embodiment", "an embodiment", or similar language means that a particular feature, structure, or characteristic described in connection with the indicated embodiment is included in at least one embodiment of the present invention. Thus, the phrases "in one embodiment", "in an embodiment", and similar language throughout this specification may, but do not necessarily, all refer to the same embodiment.

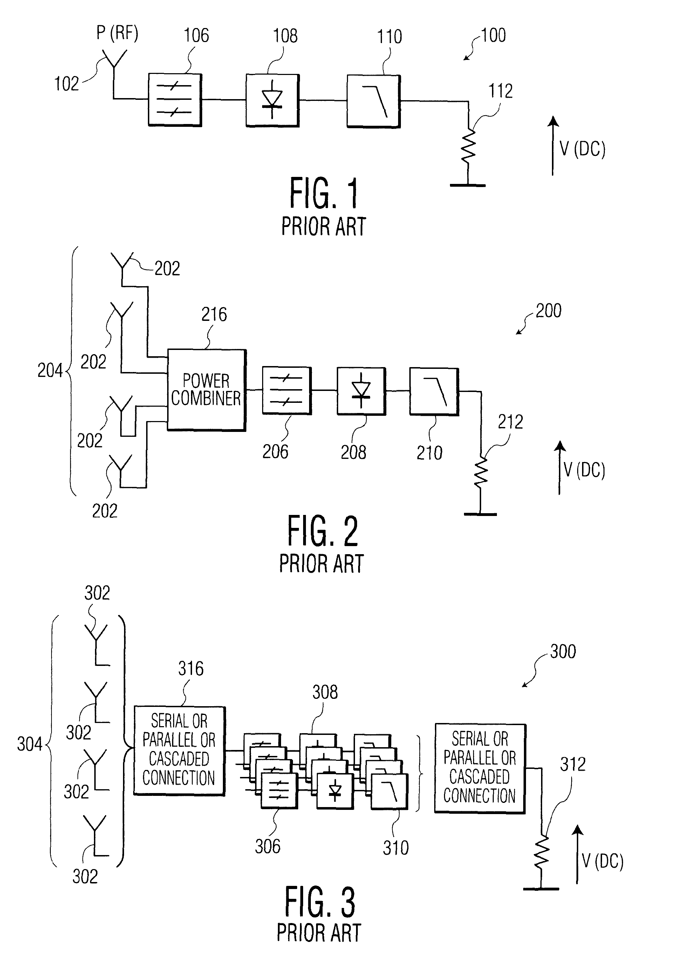

Rectennas can be used to harvest energy from energy sources such as electromagnetic energy in the form of, for example, WiFi, GSM, and satellite signals, which are present in the surrounding environment. Fig. 1 depicts a system 100 for harvesting energy that includes a rectenna. The rectenna includes an antenna 102, a filter 106, a rectifier (e.g., a diode) 108, and a low-pass filter 110 and the rectenna is connected to a load 112. In an embodiment, the filter also provides impedance matching between the antenna and the rectifier. In an embodiment, the rectenna converts electromagnetic energy, e.g., RF energy at 2.4 GHz, into direct current (DC) voltage.

In order to increase the voltage that can be output, energy harvesting systems have been equipped with antenna arrays. Fig. 2 depicts a system 200 for harvesting energy in which a rectenna includes an antenna array 204 having multiple antennas 202. In the system of Fig. 2, the outputs from the antennas of the antenna array are combined to a single line at a power combiner 216. The output signal from the combiner is then provided in series to a filter 206, to a rectifier 208, and then to a low-pass filter 210. In an embodiment, the filter also provides impedance matching between the antenna and the rectifier. The generated DC voltage is provided to a load 212.

Fig. 3 depicts another embodiment of a system 300 for harvesting energy. In the system of Fig. 3, the rectenna includes multiple antennas 302 in an antenna array 304, multiple parallel filters 306, multiple parallel rectifiers 308, and multiple parallel low-pass filters 310. The antennas are connected to the filters at a connector block 316, which may include series, parallel, and/or cascaded connections. The low-pass filters are connected to a load at a connector block 320, which may include series, parallel, and/or cascaded connections. The generated DC voltage is provided to a load 312.

In known embodiments of an energy harvesting system, passive and active components are soldered or glued to a printed circuit board. For some applications, the printed circuit board can be flexible. Typical antennas for such energy harvesting systems include microstrip antennas and coplanar antennas.

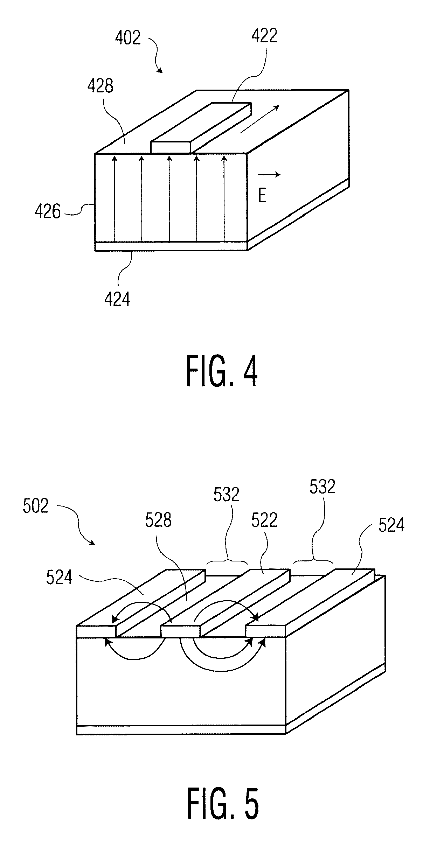

Fig. 4 depicts an embodiment of a microstrip antenna 402 as is known in the field.
The microstrip antenna includes a signal line 422 and a ground plane 424 that are separated by a dielectric substrate 426. The signal line and ground plane are electrodes made of conductive materials such as thin metal layers of copper and the substrate is a rigid dielectric such as fiberglass reinforced epoxy laminate (e.g., FR4) or ceramic. As shown in Fig. 4, the signal line is located on a top major surface 428 of the substrate, the ground plane is located on a bottom major surface (not shown) of the substrate and the signal line, the ground plane, and the dielectric substrate are in a "stacked" configuration with each element occupying a different horizontal plane. In the presence of microwave energy and as illustrated in Fig. 4, an electric field is generated between the two electrodes (the signal line and the ground plane), and a corresponding signal is carried in the signal line.

Fig. 5 depicts an embodiment of a coplanar antenna 502 as is known in the field. The coplanar antenna includes a signal line 522 and a ground plane 524 that are both located on the top major surface 528 of a dielectric substrate 526. Again, the signal line and ground plane are electrodes made of a conductive material such as thin metal layers of copper and the substrate is a rigid dielectric such as FR4 or ceramic. As shown in Fig. 5, the signal line and ground plane occupy the same horizontal plane and the signal line is separated from the ground planes by gaps 532 in the horizontal layer. In the embodiment of Fig. 5, the gaps are void space filled by the ambient environment, e.g., by air. In the presence of microwave energy and as illustrated in Fig. 5, electric fields are generated between the signal line and the ground plane and a corresponding signal is carried by the signal line.

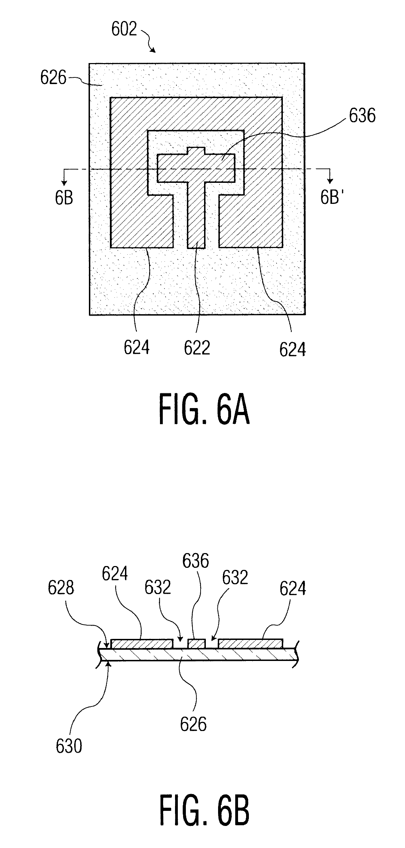

Figs. 6A and 6B depict an embodiment of a coplanar patch antenna that can be used in an energy harvesting system. Fig. 6A is a top plan view of the coplanar patch antenna formed on the top major surface of a substrate as described above with reference to Fig. 5. The coplanar patch antenna includes a radiating element 636 (e.g., a patch), a signal line 622, and a ground plane 624. As shown in Fig. 6A, the patch acts as one electrode of the antenna and the ground plane acts as another electrode of the antenna. A generated signal is carried on the signal line. Fig. 6B depicts a side cutaway view of the coplanar patch antenna at section 6B-6B'. As illustrated in the side cutaway view, the patch 636 and the ground plane 624 are located on the top major surface 628 of the substrate (which is opposite the bottom major surface 630) and are in the same horizontal plane. The dielectric substrate is in a horizontal plane that is different from the horizontal plane of the patch and ground plane. Figs. 6A and 6B also illustrate air gaps 632 that exist between the signal line and the ground plane in their common horizontal plane. In an embodiment, the dimensions of the gaps and of the line widths are configured to achieve a certain impedance, e.g., 50 ohms.

Although the coplanar antenna 602 described above with reference to Figs. 6A and 6B is able to harvest energy from microwave energy in the surrounding environment, the coplanar antenna can be difficult to integrate with items such as garments. For example, the rigidity of FR4 and ceramic and the metal conductors can make it impractical to integrate such antennas into wearable electronics. In accordance with an embodiment of the invention, a coplanar antenna system is formed by connecting conductive textile portions to non-conductive textile portions, where the conductive textile portions have conductive fibers and the non-conductive textile portions have nonconductive fibers. Using conductive textiles and non-conductive textiles to form a coplanar antenna system allows the antenna system to be integrated directly into an item such as a garment. Integrating an antenna system directly into an item such as a garment enables the garment to be equipped with an energy harvesting system while maintaining the flexibility and functionality of the garment. In an embodiment, the conductive textile portions and non-conductive textile portions are connected to each other side-by-side to form a coplanar antenna system without the need for a rigid dielectric substrate such as FR4 or ceramic. Additionally, the conductive and nonconductive textiles can be patterned to form signal lines that carry captured signals between components of the energy harvesting system. Further, the conductive and nonconductive textiles can be patterned to form other passive circuits of an energy harvesting system, such as combiners and filters.

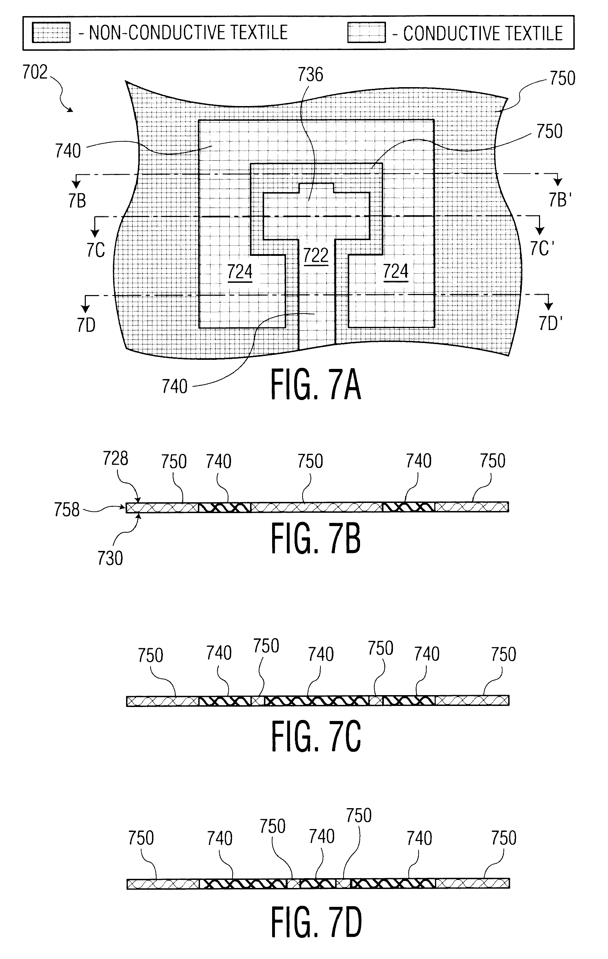

Figs. 7A - 7D depict an example of a system 702 in accordance with an embodiment of the invention. Fig. 7A is a top view of the antenna system that depicts conductive textile portions 740 and non-conductive textile portions 750 that form a coplanar antenna system. The conductive textile portions include a conductive textile patch 736, a conductive textile signal line 722, and a conductive textile ground plane 724. The conductive textile patch and the conductive textile signal line are electrically separated from the conductive textile ground plane by a nonconductive textile portion. The conductive textile ground plane is surrounded by a conductive textile portion. An important aspect of the antenna system is that the conductive textile portions and the nonconductive textile portions are coplanar, e.g. in the same plane. For example, the conductive textile portions and the non-conductive textile portions are in the same horizontal plane. Figs. 7B - 7D depict three different cross-sections of the antenna system that illustrate the coplanar nature of the conductive and non-conductive textile portions. Fig. 7B is a cross-sectional view of the antenna system at line 7B-7B', which illustrates that the conductive textile portions and non-conductive textile portions are coplanar. Fig. 7C is a cross-sectional view of the antenna system at line 7C-7C', which illustrates that the conductive textile portions and non-conductive textile portions are coplanar. Fig. 7D is a cross-sectional view of the antenna system at line 7D-7D', which illustrates that the conductive textile portions and non-conductive textile portions are coplanar. As illustrated in Figs. 7A - 7D, the conductive textile portions have top and bottom major surfaces 728 and 730 and perimeter edges 758 and the non-conductive textile portions have top and bottom major surfaces 728 and 730 and perimeter edges 758 and the conductive textile portions are connected to the non-conductive textile portions at the respective perimeter edges. Because the conductive textile portions and non-conductive textile portions are coplanar, the antenna system can be integrated directly into an item such as a garment while maintaining the flexibility and functionality of the garment. For example, a garment made primarily of non-conductive textile can include a textile-based antenna system integrated directly into the fabric of the garment.

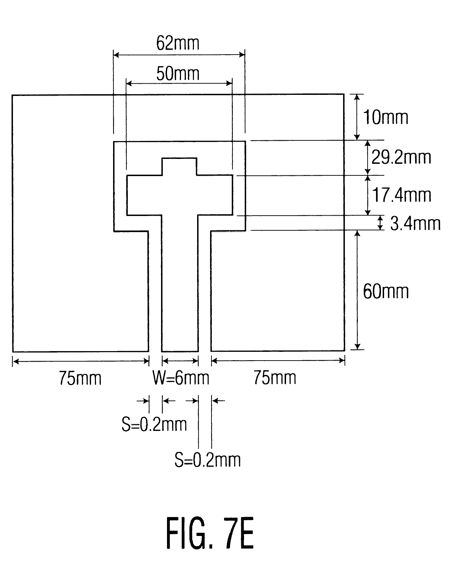

Fig. 7E depicts example dimensions of the coplanar antenna system 702 of Figs. 7A - 7D. In an embodiment, the antenna system of Figs. 7A - 7E uses an Aluminum-based conductive textile 740 and a non-conductive textile 750 with a relative permittivity, Er, of Er≈3, wherein the relative permittivity of a material is its dielectric permittivity expressed as a ratio relative to the permittivity of a vacuum. In an embodiment, the textiles are formed from cylindrical fibers that have a diameter of approximately 30um, although fibers with other dimensions are possible. In an embodiment, the space between two fibers is approximately 50um and the space is filled with air (Er≈1). In the embodiment of Fig. 7E, the signal line is about 5mm wide (W) and the distance between the signal line and the ground plane (referred to as the "slot" (S)), is about 0.2 mm, such that W/(W+2S) achieves approximately 50 ohms impedance. In an embodiment, a slot should be at least one fiber wide.

In the embodiment of Fig. 7A, the patch portion 736 and the signal line portion 722 of the conductive textile are formed from at least some common fibers. For example, some vertically aligned fibers may span across both the patch portion and the signal line portion. Additionally, although a patch portion with a particular shape is shown in Fig. 7A, the shape of the patch portion could be different. For example, antenna shapes may include a "Z" shaped antenna and/or a Vivaldi antenna of course other shapes are possible.

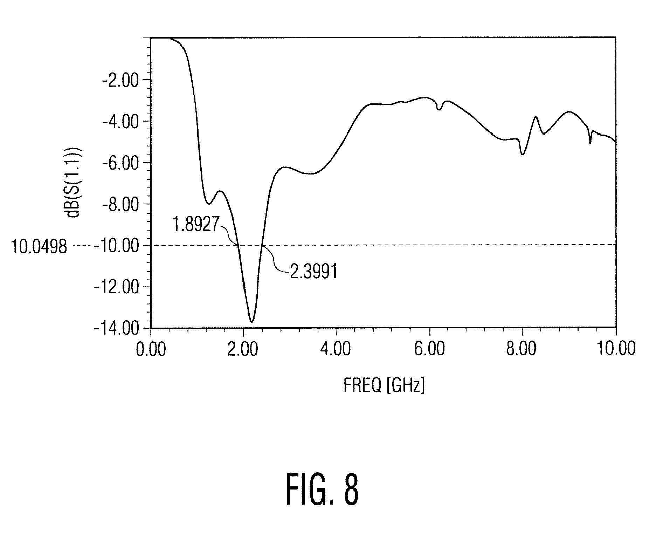

Fig. 8 is an example simulation of resonance vs. frequency for the antenna system of Figs. 7A - 7E. As shown in Fig. 8, the antenna system has good resonance at around 2 GHz. The example simulation shown in Fig. 8 was conducted using a three-dimensional (3D) electromagnetic high-frequency structure simulator (HFSS).

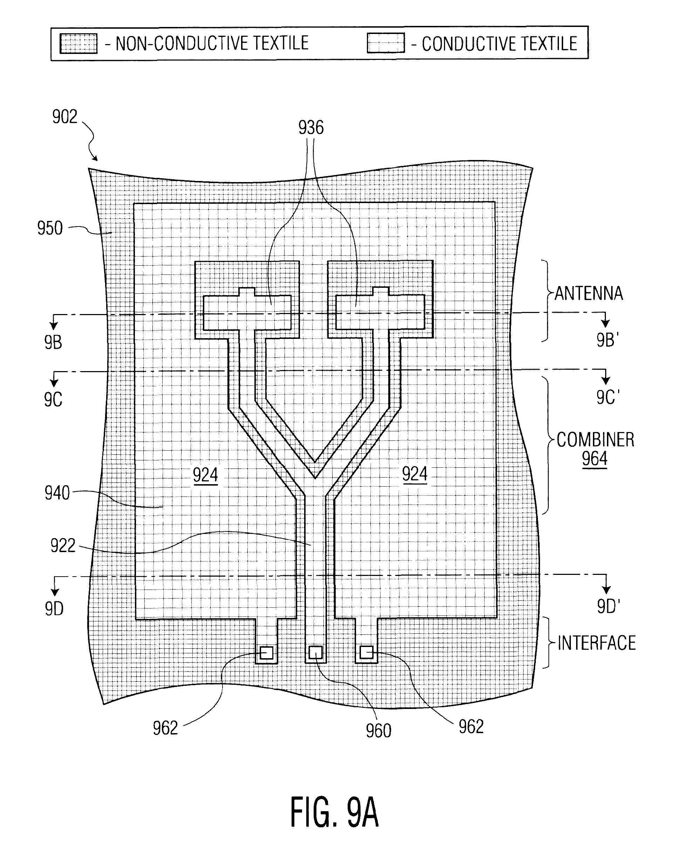

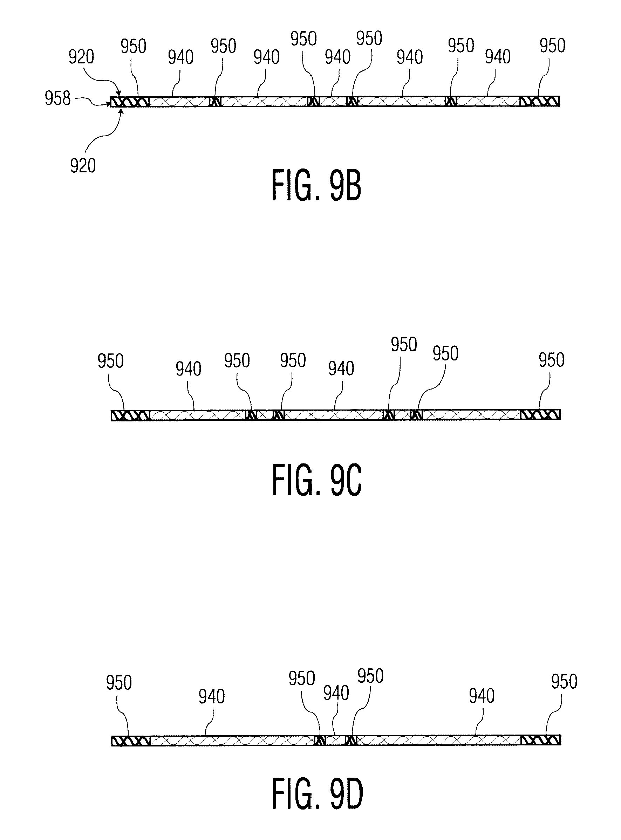

In an embodiment, a textile-based antenna system includes a coplanar antenna array. Figs. 9A - 9D depict an embodiment of an antenna system 902 that includes conductive textile portions 940 and non-conductive textile portions 950 formed into a coplanar antenna array. As described above with reference to Figs. 7A - 7E, conductive textiles and non-conductive textiles are patterned to form patches 939, signal lines 922, and a ground plane 925. As with the antenna system of Figs. 7A - 7E, an important aspect of the antenna system of Figs. 9A - 9D is that the conductive textile portions and the nonconductive textile portions are coplanar, e.g., in the same plane. For example, the conductive textile portions and the non-conductive textile portions are in the same horizontal plane. Figs. 9B - 9D depict three different cross-sections of the antenna system that illustrate the coplanar nature of the conductive and non-conductive textile portions. Fig. 9B is a cross-sectional view of the antenna system at line 9B-9B', which illustrates that the conductive textile portions and non-conductive textile portions are coplanar. Fig. 9C is a cross-sectional view of the antenna system at line 9C-9C', which illustrates that the conductive textile portions and non-conductive textile portions are coplanar. Fig. 9D is a cross-sectional view of the antenna system at line 9D-9D', which illustrates that the conductive textile portions and non-conductive textile portions are coplanar. As illustrated in Figs. 9A - 9D, the conductive textile portions have top and bottom major surfaces 928 and 930 and perimeter edges 958 and the non-conductive textile portions have top and bottom major surfaces and perimeter edges and the conductive textile portions are connected to the non-conductive textile portions at the respective perimeter edges. Because the conductive textile portions and non-conductive textile portions are coplanar, the antenna system can be integrated directly into an item such as a garment while maintaining the flexibility and functionality of the garment. For example, a garment made primarily of non-conductive textile can include a textile-based antenna system integrated directly into the fabric of the garment.

Although only two patches 936 are shown in Fig. 9A, an antenna array with more than two patches is possible. Additionally, the patches and signal lines 922 can be combined in various different ways. In the antenna system of Fig. 9A, signal lines from each patch feed into a single signal line to form a combiner. Fig. 9A also depicts a signal line interface 960 and two ground plane interfaces 962 that are coupled to the respective portions of conductive textile 740. The interfaces as shown in Fig. 9A include interface pads of conductive material that enable the connection to other circuits, such as active circuits that may be embodied as an IC device. In an antenna array that is designed from microwave frequencies, it is desirable to match the impedance of the combiner inputs to the load of the combiner. In the antenna array of Figs. 9A - 9D, the output impedance of each antenna is approximately Zc=50Ohms, for example. If combined, it will result in 25 Ohms, a loss of half of the signal. Therefore, the combiner should be configured in such a way that signal is not lost to the load Z_{c}. In an embodiment, in the two arms of the combiner of Fig. 9A, the signal lines have a characteristic impedance of 1.414 * Z_{c}. The signal lines are connected to one output and the output impedance of this combiner is equal to Z_{c}, and thus is matched.

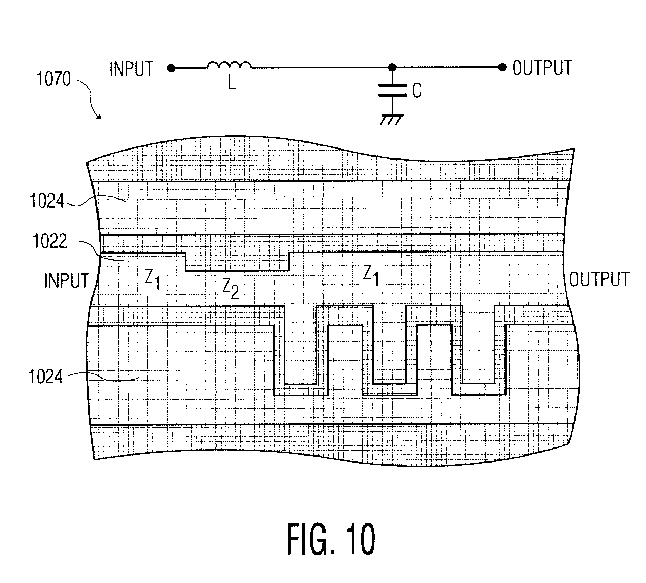

The conductive and nonconductive textiles can be patterned to form other passive circuits, such as combiners and filters, which may be part of an energy harvesting system. Fig. 9A depicts an example embodiment of a combiner 964. Fig. 10 depicts an example embodiment of a filter 1070 that is formed from coplanar portions of conductive and non-conductive textiles. As shown in Fig. 10, conductive textile portions form a signal line 1022 and conductive textile portions form a ground plane 1024. As indicated by the circuit diagram above the antenna structure, an inductor (L) is formed by a narrowed portion of the signal line and a capacitor (C) is formed by interdigitated portions of the signal line and the ground plane. The inductor is formed to have a high characteristic impedance relative to the rest of the signal line, e.g., z₂ >>z₁. Although two examples of passive circuits are shown in Figs. 9 and 10, other passive circuits can be formed from coplanar portions of conductive and non-conductive textiles.

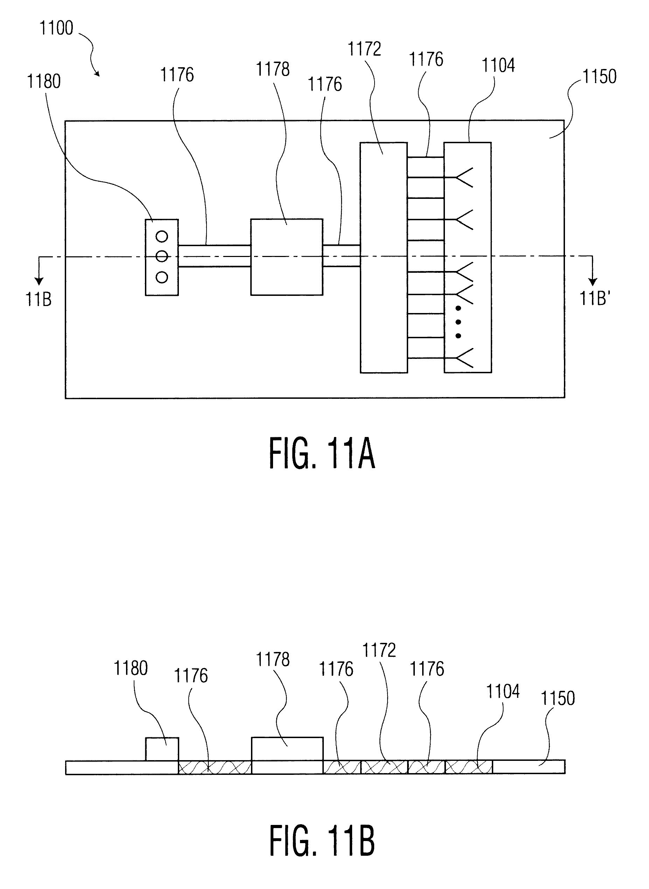

Antenna systems and passive elements such as those described above with reference to Fig. 7A - 7E, 9A - 9D, and 10 can be used to form an energy harvesting system that is integrated into an item such as a garment. Figs. 11A and 11B depict an embodiment of an energy harvesting system 1100 that includes a textile-based antenna system and passive elements. With reference to Fig. 11A, the energy harvesting system includes a textile-based coplanar antenna array 1104, textile-based signal lines 1176, textile-based passive circuits 1172 (e.g., a combiner and a filter), textile-based signal lines 1176, an active circuit 1178 (e.g., an IC device), textile-based signal lines 1176, and a connector 1180. Fig. 11B is a cross-sectional view of the energy harvesting system at line 11B-11B', which illustrates that the conductive textile portions and non-conductive textile portions are coplanar.

In an embodiment, the textile-based coplanar antenna system 1104 of Figs. 11A and 11B is an antenna system that includes multiple antennas, such as the antennas described with reference to Figs. 7A - 7E and 9A - 9D, in an antenna array. Other arrangements of coplanar textile-based antenna systems are possible. The signal lines 1176 between the antenna system 1104 and the passive circuits 1172 electrically connect the antenna system to the passive circuits. In an embodiment, the signal lines are portions of conductive textile insulated by portions of non-conductive textile to create conductive paths, or textile-based "wires." As shown in Fig. 11B, the conductive textile portions of the signal lines are in the same plane as the other conductive textile portions and as the non-conductive textile portions. The passive circuits are formed from patterns of conductive textile portions and non-conductive textile portions. Example passive circuits include combiners and filters as described above with reference to Figs. 9A and 10. In an embodiment, the passive circuits of Figs. 11A and 11B include combiners to combine the signals from the antennas and at least one filter to filter the signals from the antennas. The signal lines between the passive circuits and the active circuits 1178 electrically connect the passive circuits to the active circuits. In an embodiment, the signal lines include interfaces at the ends nearest the active circuits to connect the signal lines to the active circuits. In an embodiment, the interfaces 960 and 962 are similar to the interfaces shown in Fig. 9A, which include interface pads for connection to an IC device. In an embodiment, the signal lines are portions of conductive textile insulated by portions of non-conductive textile and as shown in Fig. 11B, the conductive textile portions of the signal lines are in the same plane as the other conductive textile portions and as the non-conductive textile portions. The active circuits include, for example, a low pass filter that is fabricated on a semiconductor substrate and packaged into an IC device as is known in the field. In an embodiment, an IC device including active circuits is attached on top of the textile, e.g., on top of a portion of the non-conductive textile. The signal lines between the active circuits and the connector 1180 electrically connect the active circuits to the connector. In an embodiment, the signal lines include interfaces at their ends to connect the signal lines to the active circuits and to the connector. In an embodiment, the interfaces are similar to the interfaces shown in Fig. 9A, which include interface pads for connection to an IC device and/or to a connector. In an embodiment, the signal lines are portions of conductive textile insulated by portions of non-conductive textile and as shown in Fig. 11B, the conductive textile portions of the signal lines are in the same plane as the other conductive textile portions and as the non-conductive textile portions. The connector is an electrical connector that enables the energy harvesting system to be electrically connected to a load. In an embodiment, the connector is attached on top of the textile, e.g., on top of a portion of the non-conductive textile.

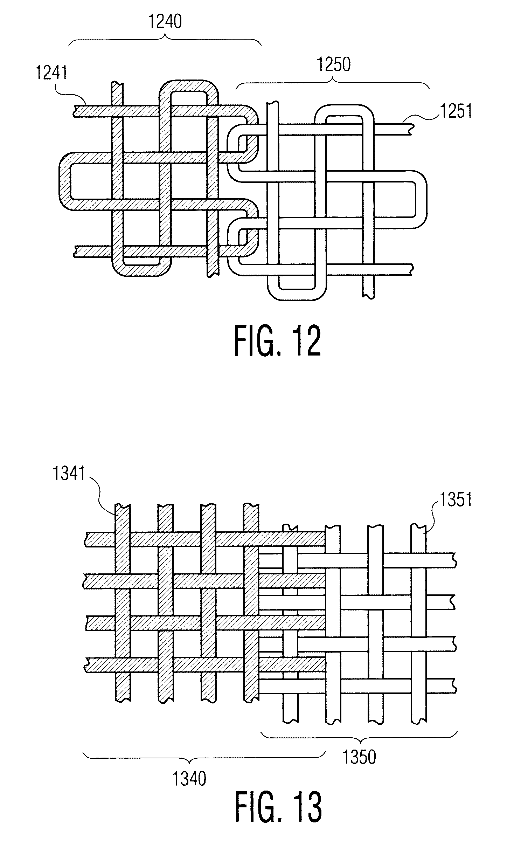

As described above, the conductive textile portions and non-conductive textile portions can be connected to each other side-by-side to form a coplanar antenna system without the need for a rigid dielectric substrate such as FR4 or ceramic. There are various ways in which the conductive textile portions and non-conductive textile portions can be connected to each other side-by-side to form a coplanar antenna system. Fig. 12 depicts an expanded view of a portion of a conductive textile 1240 and a portion of a non-conductive textile 1250 that are connected to each other side-by-side in an interlaced manner. As illustrated in Fig. 12, one fiber 1241 of the conductive textile is interlaced with one fiber 1251 of the non-conductive textile so that the two textiles are interlocked with each other. Although one example of interlaced fibers is shown in Fig. 12, other interlacing arrangements are possible. Additionally, although one conductive fiber is shown interlaced with one non-conductive fiber, multiple fibers can be interlaced with each other.

Fig. 13 depicts an expanded view of a conductive textile 1340 and a non-conductive textile 1350 that are connected to each other side-by-side in an embedded manner. As illustrated in Fig. 13, fibers 1341 of the conductive textile overlap with fibers 1351 of the non-conductive textile. The overlapping fibers may then be adhered to each other by, for example, adhesive material and/or heat treatment. Although one example of embedded fibers is shown in Fig. 13, other embedding arrangements are possible. Additionally, although single fibers are interlaced with each other, multiple fibers can be interlaced with each other. Further, the conductive textile and non-conductive textile can be connected to each other side

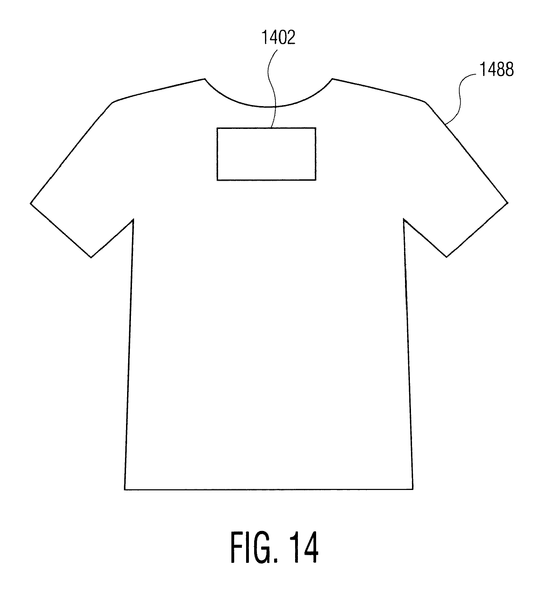

The antenna systems and/or energy harvesting systems described above with reference to Figs. 7A - 13 can be integrated into an item such as a garment. Fig. 14 depicts an embodiment of a garment 1488, such as a shirt, which includes an antenna system and/or energy harvesting system 1402 as described above with reference to Figs. 7A - 13 integrated into the garment. For example, the shirt includes a combination of coplanar conductive and non-conductive textiles that form an antenna system, an energy harvesting system, and/or portions thereof. Although an example of a garment is shown in Fig. 14, the antenna systems and/or energy harvesting systems described above with reference to Figs. 7A - 13 can be integrated into other items such as tents, umbrellas, and furniture. Integration into other items is also possible.

As used herein, a textile can be a material made of natural or artificial fibers and used for the manufacture of items such as clothing and furniture. In an embodiment, a textile is a material made of interlacing fibers and a fiber is an extremely long, pliable, cohesive natural or manufactured threadlike object from which yarns are spun to be woven into textiles.

Various different types of conductive textiles and non-conductive textiles can be used to form the antenna systems and/or energy harvesting systems as described above with reference to Figs. 7A - 13. Examples of conductive textiles include textiles made of copper filament, silver-plated copper, brass, silver-plated brass filaments, aluminum filaments, copper-aluminum filaments, carbon, nickel, titanium, and steel. Conductive textiles may also include fabric or yarn completely and uniformly coated with a conductive material such as doped polypyrrole, an inherently conductive polymer. Examples of non-conductive textiles include cotton, polymer fiber, polyester, and nylon.

As used herein, conductive textiles refer to textiles that are relatively good electrical conductors. For example, a relatively good electrical conductor has a resistivity below 1 Ω·mm²/m.

As used herein, non-conductive textiles refer to textiles that are relatively poor electrical conductors. For example, a relatively poor electrical conductor has a resistivity of at least 100 Ω·mm²/m.

In an embodiment, energy is harvested from electromagnetic energy in frequency ranges of, for example, very high frequency (VHF) to the millimeter wave range (100MHz to 94GHz). In an embodiment, energy is harvested from electromagnetic energy in frequency ranges of, for example, cellular bands of 900MHz to 2.2GHz, wireless LAN (WLAN) or "WiFi" bands at 2.4GHz, and/or industrial, scientific, and medical (ISM) bands of, for example, 52 to 62GHz.

Embodiments described above relate to antenna systems for energy harvesting and energy harvesting systems. In other embodiments, conductive textile portions and non-conductive textile portions can be connected to each other in the same plane (e.g., side-by-side) to form other coplanar electronic circuits such as, for example, impedance matching circuits, couplers, slot transmission lines, coupled coplanar transmission lines, and hybrid couplers. In such coplanar electronic circuits, the conductive textile portions have top and bottom major surfaces and perimeter edges and the non-conductive textile portions have top and bottom major surfaces and perimeter edges and the conductive textile portions are connected to the non-conductive textile portions at the respective perimeter edges. For example, the conductive textile portions and non-conductive textile portions are connected as illustrated in Figs. 12 and 13. Because the conductive textile portions and non-conductive textile portions are coplanar, the electronic circuits can be integrated directly into an item such as a garment while maintaining the flexibility and functionality of the garment. For example, a garment made primarily of non-conductive textile can include a textile-based electronic circuit integrated directly into the fabric of the garment.

In the above description, specific details of various embodiments are provided. However, some embodiments may be practiced with less than all of these specific details. In other instances, certain methods, procedures, components, structures, and/or functions are described in no more detail than to enable the various embodiments of the invention, for the sake of brevity and clarity.

Although specific embodiments of the invention have been described and illustrated, the invention is not to be limited to the specific forms or arrangements of parts so described and illustrated. The scope of the invention is to be defined by the claims appended hereto and their equivalents.

The present disclosure extends to the following series of lettered clauses:
A. A system comprising: an antenna array formed of coplanar conductive textile portions and non-conductive textile portions; wherein signal elements and ground elements of the antenna array are formed from the conductive textile portions; and wherein the signal elements of the antenna array are electrically insulated from the ground elements of the antenna array by at least one of the non-conductive textile portions.
B. The system of clause A wherein the conductive textile portions comprise interlaced conductive fibers and the non-conductive textile portions comprise interlaced non-conductive fibers.
C. The system of clause A further comprising a combiner, formed from conductive textile portions and non-conductive textile portions, which electrically connects signal elements of the antenna array.
D. The system of clause A further comprising a filter, formed from the conductive textile portions and the non-conductive textile portions, which filters an output of the combiner and provides impedance matching.

## Claims

1. A system comprising:
conductive textile portions; and
non-conductive textile portions;
wherein the conductive textile portions have conductive fibers and the non-conductive textile portions have non-conductive fibers;
wherein the conductive textile portions are connected to the non-conductive textile portions in the form of a coplanar antenna system.

2. The system of claim 1 wherein the conductive textile portions have top and bottom major surfaces and perimeter edges and the non-conductive textile portions have top and bottom major surfaces and perimeter edges and wherein the conductive textile portions are connected to the non-conductive textile portions at the respective perimeter edges.

3. The system of claim 1 or 2, wherein:
the conductive textile portions comprise;
a conductive textile patch;
a conductive textile signal line electrically connected to the conductive textile patch; and
a conductive textile ground plane; and
the non-conductive textile portions electrically separate the conductive textile patch and the conductive textile signal line from the conductive textile ground plane.

4. The system of claim 3 further including a signal line interface coupled to the conductive textile signal line and at least two ground plane interfaces coupled to the conductive textile ground plane.

5. The system of claim 1 wherein the coplanar antenna system comprises an array of patch antennas formed from the conductive textile portions and the non-conductive textile portions.

6. The system of claim 5 wherein the coplanar antenna system comprises a combiner, formed from the conductive textile portions and the non-conductive textile portions, which electrically connects the array of patch antennas.

7. The system of any preceding claim wherein the coplanar antenna system comprises a filter, formed from the conductive textile portions and the non-conductive textile portions, which filters a signal from the coplanar antenna system and provides impedance matching, and, in the case that this claim depends from claim 6, the signal from the coplanar antenna system is an output of the combiner.

8. An antenna system comprising:
a conductive textile patch;
a conductive textile signal line electrically connected to the conductive textile patch;
a conductive textile ground plane; and
non-conductive textile portions that electrically separate the conductive textile patch and the conductive textile signal line from the conductive textile ground plane;
wherein the conductive textile patch, the conductive textile signal line, the conductive textile ground plane, and the non-conductive textile portions are connected to each other in the same plane.

9. The antenna system of claim 8 wherein the conductive textile patch, the conductive textile signal line, and the conductive textile ground plane have top and bottom major surfaces and perimeter edges and the non-conductive textile portions have top and bottom major surfaces and perimeter edges and wherein the conductive textile portions are connected to the non-conductive textile portions at the respective perimeter edges.

10. The antenna system of claim 8 wherein the conductive textile patch, the conductive textile signal line, and the conductive textile ground plane comprise interlaced conductive fibers and wherein the non-conductive textile portions comprise interlaced non-conductive fibers.

11. The antenna system of claim 8 wherein the conductive textiles and non-conductive textiles are connected to each other by interlacing of respective conductive and non-conductive fibers.

12. The antenna system of claim 8 further including a signal line interface coupled to the conductive textile signal line and at least two ground plane interfaces coupled to the conductive textile ground plane.

13. The antenna system of claim 8 wherein at least some of the non-conductive textile portions surround the conductive textile patch and the conductive textile signal line.

14. The system of claim 8 further comprising an antenna array and a combiner, formed from conductive textile portions and non-conductive textile portions, wherein the combiner electrically connects signal lines of the antenna array.

15. The system of claim 14 further comprising a filter, formed from conductive textile portions and non-conductive textile portions, which filters an output of the combiner.
